(19) Europäisches Patentamt
European Patent Office
Office européen des brevets

(11) EP 2 348 556 A1

(12) **EUROPEAN PATENT APPLICATION**
published in accordance with Art. 153(4) EPC

(43) Date of publication:
**27.07.2011 Bulletin 2011/30**

(21) Application number: **09823310.9**

(22) Date of filing: **28.10.2009**

(51) Int Cl.:
***H01L 51/42*** *(2006.01)*

(86) International application number:
**PCT/JP2009/005693**

(87) International publication number:
**WO 2010/050197 (06.05.2010 Gazette 2010/18)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **30.10.2008 JP 2008279880**

(71) Applicant: **Idemitsu Kosan Co., Ltd.**
**Chiyoda-ku**
**Tokyo 100-8321 (JP)**

(72) Inventors:
- **MATSUURA, Masahide**
**Sodegaura-shi**
**Chiba 299-0293 (JP)**
- **IKEDA, Hidetsugu**
**Sodegaura-shi**
**Chiba 299-0293 (JP)**
- **NAKAMURA, Hiroaki**
**Sodegaura-shi**
**Chiba 299-0293 (JP)**
- **IWAMOTO, Shintaro**
**Sodegaura-shi**
**Chiba 299-0293 (JP)**

(74) Representative: **Gille Hrabal Struck Neidlein Prop Roos**
**Patentanwälte**
**Brucknerstrasse 20**
**40593 Düsseldorf (DE)**

(54) **ORGANIC THIN-FILM SOLAR CELL**

(57) An organic thin film solar cell including a pair of electrodes and at least one organic layer including two or more organic compounds, which is between the pair of electrodes, wherein a difference ($\Delta Af$) in affinity levels between the two main organic compounds of the at least two organic compounds satisfies the following equation (a):

$$0.5\ eV < \Delta Af < 2.0\ eV \quad \cdots (a).$$

EP 2 348 556 A1

## Description

### TECHNICAL FIELD

The invention relates to an organic thin film solar cell.

### BACKGROUND ART

An organic thin film solar cell is a device which outputs electrical power through incidence of light, as is represented by a photodiode and an imaging device which convert a light signal to an electric signal, or by a solar cell which converts light energy to electric energy. Thus, it is a device which makes a response opposite to an electroluminescence (EL) device which outputs light through input of electric power. Recently, the solar cell remarkably attracts attention as a clean energy source, backed by the problems of exhaustion of fossil fuels or global warming, and researches and development of the solar cell have become conducted actively.
Heretofore, solar cells which have been put into practical use are silicon-based ones using monocrystalline Si, polycrystalline Si, amorphous Si or the like. As the problems in these solar cells that they are expensive, the raw material Si and the like suffer shortage or the like become an issue, demand for next-generation solar cells gradually increases. Under such circumstances, because of organic solar cells being inexpensive, having low toxicity and no concern of raw material shortage, the organic solar cell attracts much attention as the next-generation solar cell which follows the silicon-based solar cell.
An organic solar cell is basically composed of an n-layer which transfers electrons and a p-layer which transfers holes, and is divided into two main types based on the materials forming each layer.
A solar cell in which as the n-layer, a sensitizing dye such as ruthenium dye is monolayer-adsorbed on the surface of an inorganic semiconductor such as titania, and an electrolyte solution is used as the p-layer, is called as a dye-sensitized solar cell (so-called a Graetzel cell). Researches on the dye-sensitized solar cell have been energetically conducted since 1991, in view of its high conversion efficiency. However, it has defects that leakage occurs after use for a long period of time, etc. because of using a solution. In order to overcome such defects, researches to obtain a whole solid-type dye-sensitized solar cell by solidifying an electrolyte solution are recently conducted. However, the technology to perfuse an organic substance to fine pores of porous titania is very difficult, therefore, such a cell which exhibits high conversion efficiency with good reproducibility is not completed at this present.
On the other hand, an organic thin film solar cell in which both of the n-layer and the p-layer are formed from organic thin films has no defect such as leakage of the solution because it is a whole solid-type. Recently, the organic thin film solar cell gathers attention and is energetically studied since it is easily fabricated and uses no ruthenium which is a rare metal.
The organic thin film solar cell has been advanced in the studies on a monolayer film formed of a merocyanine dye or the like at the beginning. It was found that the conversion efficiency increases by using a multilayer film of a p-layer/n-layer, and thereafter, such a multilayer film has been mainly employed. The materials used at that time were copper phthalocyanine (CuPc) for the p-layer and peryleneimides (PTCBI) for the n-layer.
Thereafter, it was found that increase of the number of stacking layers by inserting an i-layer (a mixture layer of a p-material and an n-material) between the p-layer and the n-layer results in improvement in the conversion efficiency. However, the materials used at that time were also phthalocyanines and peryleneimides as ever. Subsequently, it was found that the conversion efficiency is further improved by employing a stack cell structure in which several multilayers of a p-layer/i-layer/n-layer are stacked. The material system at that time was phthalocyanines and $C_{60}$.
As mentioned above, the conversion efficiency of the organic thin film solar cell has been improved by optimizations in the cell structure and the morphology. However, the material system used therefor did not make progress from the beginning, and phthalocyanines, peryleneimides and $C_{60}$s have been used as ever. Under such circumstances, new material systems in place of the above-mentioned conventional materials are eagerly desired to be developed.
The operation process of an organic thin film solar cell is generally composed of elementary steps of: (1) light absorption and exciton generation, (2) exciton diffusion, (3) charge separation, (4) carrier transfer and (5) electromotive force generation. In general, there are few organic substances having the absorption property which agrees with the solar spectrum as well as almost organic substances have the low carrier mobility. Therefore, high conversion efficiency could hardly be attained. Further, an organic thin film solar cell is affected by the properties of the organic thin film since it is a completely solidified cell. Furthermore, there was a problem that an organic thin film solar cell was affected by material molecules for forming the organic thin film.
Patent Document 1 discloses organic co-deposited films of phthalocyanines and peryleneimides. However, the phthalocyanines and perylene-imides are very difficult to be controlled in the film formation rate during vacuum vapor deposition in view of their sublimation properties. Thus, there is a problem that a short circuit is likely to occur. Further, they require skilled film formation control, as well as the phthalocyanines have problems of a higher deposition temperature

and requirement for larger energy for fabricating a device.

Patent Document 2 discloses an organic solar cell with a hole-blocking layer having an ionization potential larger than that of a compound semiconductor particle contained in an active layer. However, the ionization potential is a value reflecting the energy level of holes, and thus, it does not define the energy level of electrons or the electron mobility.

[Related Art Documents]

[Patent Document]

[Patent Document 1] JP-A-2002-76027
[Patent Document 2] JP-A-2004-165516

SUMMARY OF THE INVENTION

An object of the invention is to provide an organic thin film solar cell which exhibits an efficient photoelectric conversion property.

According to the invention, the following organic thin film solar cell, etc. are provided.

1. An organic thin film solar cell comprising a pair of electrodes and one or more organic layers formed of two or more organic compounds, which are between the pair of electrodes,
wherein the difference ($\Delta$Af) in affinity level between two main organic compounds of the two or more organic compounds satisfies the following equation (a):

$$0.5\ \text{eV} < \Delta \text{Af} < 2.0\ \text{eV} \quad \cdots \text{(a)}$$

2. The organic thin film solar cell according to 1, wherein at least one organic layer of the one or more organic layers is a mixture layer in which two or more organic compounds are mixed.
3. The organic thin film solar cell according to 1, wherein the one or more organic layers are two or more organic layers, and each of the two or more organic layers is formed of any one of the two or more organic compounds.
4. The organic thin film solar cell according to any one of 1 to 3, wherein the one or more organic layers comprise a p-layer, and the p-layer is formed of at least one of the two main organic compounds.
5. The organic thin film solar cell according to 4, wherein the main organic compound of which the p-layer has an energy gap of 3 eV or more.
6. The organic thin film solar cell according to 4 or 5, wherein the main organic compound of which the p-layer is formed is an organic compound having an amino group, a carbazolyl group or a fused aromatic polycyclic moiety.
7. The organic thin film solar cell according to any one of 1 to 6, wherein the two or more organic compounds are not metal complexes.

According to the invention, an organic thin film solar cell exhibiting an efficient photoelectric conversion property can be provided.

BRIEF DESCRIPTION OF THE DRAWINGS

Fig. 1 shows a chart of one example showing a result of the photoelectron spectroscopic measurement of an organic compound layer in air using a photoelectron spectrometer.
Fig. 2 shows a chart of one example of the absorption property of an organic compound measured using a spectrometer.
Fig. 3 shows a curve of I-V characteristics of a short-circuited organic thin film solar cell.

MODE FOR CARRYING OUT THE INVENTION

The organic thin film solar cell includes a pair of electrodes and one or more organic layers formed of two or

more organic compounds (such as a p-layer, an n-layer and a mixture layer of a p-material and an n-material), which are between the pair of electrodes. A difference (ΔAf) in the affinity levels between the two main organic compounds of the two or more organic compounds satisfies the following equation (a):

$$0.5\ eV<\Delta Af<2.0\ eV \quad \cdots (a).$$

In an organic thin film solar cell, the voltage is not externally impressed so that the charges generated may not necessarily transfer to the electrodes. Thus, the energy level of the material used for forming an organic layer is important in order to prevent the charge transfer to the opposite direction. When a difference in the energy level between materials becomes large, it becomes difficult for charges to transfer beyond the barrier. As a result, the charge transfer to the normal direction is accelerated.

The above-mentioned equation (a) is the condition for assuring the normal charge transfer.

In the invention, the "two main organic compounds" are an organic compound having the largest composition ratio (in molar ratio) and an organic compound having the second-largest composition ratio (in molar ratio), of all the organic compounds forming the organic layer.

For instance, in an organic thin film solar cell having the structure of a lower electrode/p-layer/n-layer/upper electrode, the p-layer and the n-layer which are organic layers are formed of organic compounds X, Y and Z. When the composition ratios of the organic compounds X, Y and Z are 50%, 30% and 20%, respectively, the two main organic compounds are the organic compounds X and Y.

The accuracy of the above-mentioned composition ratio can be set to 0.1 %.

Here, when the one or more organic layers is formed of three organic compounds and the composition ratios of the three organic compounds are 34%, 33% and 33%, respectively, it is only necessary that any one of the two compounds having a composition ratio of 33% and the organic compound having a composition ratio of 34% satisfy the equation (a).

In the same manner, when the one or more organic layers is formed of four organic compounds and each of the composition ratios of the four organic compounds is 25% (in the case where all the organic compounds have an equal composition ratio), it is only necessary that any two of the four organic compounds satisfy the equation (a).

It is preferred that the above-mentioned two or more organic compounds be not metal complexes. As the metal complexes, phthalocyanines may be mentioned.

The cell structure of the organic thin film solar cell of the invention is not particularly limited as long as it has the structure in which one or more organic layers are between the pair of electrodes. Specific examples of the cell structures include the structure in which the following constitutions are formed on a stable insulative substrate:

(1) lower electrode/p-layer/n-layer/upper electrode

(2) lower electrode/p-layer/i-layer (or a mixture layer of a p-material and an n-material)/n-layer/upper electrode

(3) lower electrode/mixture layer of a p-material and an n-material/upper electrode and structures in which the p-layer and the n-layer in the above-mentioned structures (1) and (2) are stacked in reverse order.

A buffer layer may be provided between the electrode and the organic layer, if necessary. For instance, when the buffer layer is provided in the above-mentioned structure (1), the following structures may be mentioned:

(4) lower electrode/buffer layer/p-layer/n-layer/upper electrode

(5) lower electrode/p-layer/n-layer/buffer layer/upper electrode

(6) lower electrode/buffer layer/p-layer/n-layer/buffer layer/upper electrode

In the organic thin film solar cell of the invention, one of the one or more organic layers is preferably a mixture layer in which two or more organic compounds are mixed.

The organic thin film solar cell of the invention has preferably two or more organic layers. Each of the two or more organic layers is formed of any one of the two main organic compounds. By providing two or more organic layers, formation of an electric charge path to the opposite direction can be controlled and more charges can be transferred to the normal electrode direction.

In the organic thin film solar cell of the invention, the one or more organic layers preferably includes a p-layer, and at least one of the above-mentioned two main organic compounds is a main organic compound forming the p-layer. The energy gap Eg of the main organic compound forming the p-layer is preferably $Eg \leqq 3$ eV and more preferably $Eg \leqq 2.5$ eV. By satisfying the energy gap Eg of the main organic compound forming the p-layer to be $Eg \leqq 3$ eV, light absorption during the operation process can be more increased.

For instance, sunlight is a broad wavelength band spectrum covering from the ultraviolet region to the visible region, and further to the wavelength region longer than the infrared region, and the intensity is particularly strong in the wavelength region between 500 to 700 nm. Thus, by the organic thin film solar cell satisfying the above-mentioned limitations, it can more effectively absorb the sunlight.
Here, in the invention, the "main organic compound forming the p-layer" means the organic compound having the the largest composition ratio (in molar ratio) of all the organic compounds forming the p-layer.
In the invention, the affinity level and energy gap of an organic compound can be determined by the following methods:

An organic compound to be determined is deposited in vacuo to form a layer having a thickness of 50 nm. The layer is subjected to determination using a photoelectron spectrometer (for example, AC-1 or AC-3 manufactured by Riken Keiki Co., Ltd.) under atmospheric pressure to obtain a measurement result like Fig. 1. From the result, the ionization potential (Ip) can be determined.
The above-mentioned organic compound layer is subjected to determination using a spectrometer (for example, UV-3100 manufactured by Shimadzu Corporation) to obtain an absorption property curve like Fig. 2, for example. The energy gap (Eg) of the organic compound can be determined from the absorption edge wavelength (λ edge) of the absorption property curve. From thus obtained Ip and Eg, the affinity level (Af= Ip-Eg) of the organic compound can be calculated.
However, in the invention, determination methods are not limited to the above-mentioned methods. When an organic compound to be used has parameters outside the determination limits of the above-mentioned determination apparatuses, the respective parameters can be determined by other analysis methods pursuant to the above-mentioned determination methods.

In the organic thin film solar cell of the invention, known parts or materials used for organic thin film solar cells can be used. Each of constitutive parts will be explained below.

[Organic compound layer]

The organic compound layer includes a p-layer, i-layer, a mixture layer of a p-material and an n-material, and an n-layer. Preferably, an organic compound which functions as an electron donor is used for the p-layer, and an organic compound which functions as an electron acceptor for the n-layer.
In the invention, the two main organic compounds are preferably a combination of an organic compound which functions as an electron donor and an organic compound which functions as an electron acceptor.
The organic compound which functions as an electron donor includes organic compounds having an amino group, a carbazolyl group or a fused aromatic polycyclic moiety, such as the compounds disclosed in Japanese patent application Nos. 2006-355358, 2007-283102, 2008-112795 and 2008-34764.
Use of the compound having an amino group, a carbazolyl group or a fused aromatic polycyclic moiety for the p-layer is preferred for transporting holes during the carrier transporting process in the operation process.
Specific examples of the compound having an amino group, a carbazolyl group or a fused aromatic polycyclic moiety will be shown below.

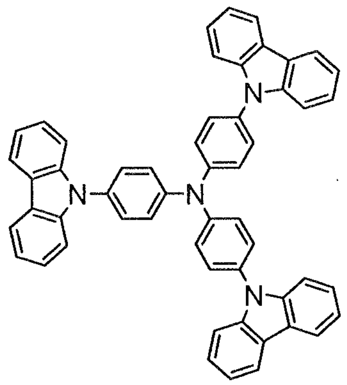

Compound 1

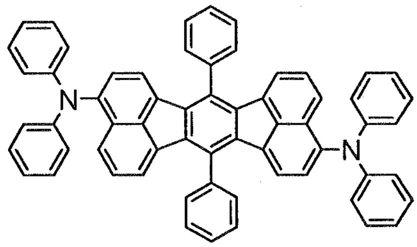

Compound 2

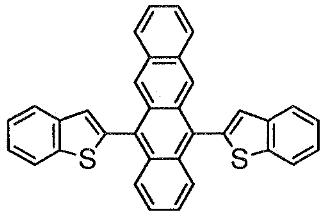

Compound 3

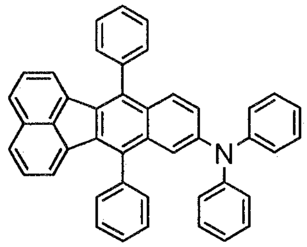

Compound 4

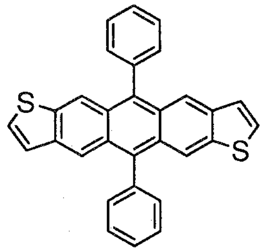

Compound 5

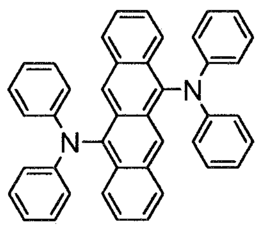

Compound 6

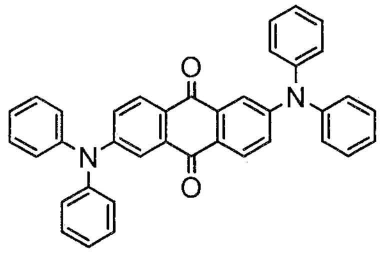

Compound 7

The organic compound which functions as an electron acceptor includes, as organic compounds, fullerene derivatives such as $C_{60}$, carbon nanotube, perylene derivatives, polycyclic quinones and quinacridone, and as polymers, CN-poly(phenylene-vinylene), MEH-CN-PPV, polymers having a -CN group or a $-CF_3$ group, those polymers substituted by a $-CF_3$ group and poly(fluorene)derivatives.
Of the above-mentioned acceptors, the fullerene derivatives such as $C_{60}$ and $C_{70}$, carbon nanotube and perylene derivatives are preferably used.
Preferred organic compounds which function as an electron acceptor are materials having high electron mobility, or materials having a small electron affinity. Use of such a material having a small electron affinity for the n-layer accomplishes a sufficient open-circuit voltage.
In addition to the organic compounds which function as an electron donor and the organic compounds which function as an electron acceptor, inorganic semiconductor compounds having an n-type characteristics can be used for the n-layer and compounds which function as a hole acceptor can be used for the p-layer.
The inorganic semiconductor compounds having an n-type characteristics include doped semiconductors and compound semiconductors such as n-Si, GaAs, CdS, PbS, CdSe, InP, $Nb_2O_5$, $WO_3$ and $Fe_2O_3$; and titanium oxides such as titanium dioxide ($TiO_2$), titanium monoxide (TiO) and dititanium trioxide ($Ti_2O_3$); and conductive oxides such as zinc oxide (ZnO) and tin oxide ($SnO_2$).
The above-mentioned inorganic semiconductor compounds having an n-type characteristic may be used alone or in combination of two or more kinds. Titanium oxide is preferably used and titanium dioxide is particularly preferably used.
The compound which functions as a hole acceptor includes, as organic compounds, amine compounds represented by N,N'-bis(3-tolyl)-N,N'-diphenylbenzidine (mTPD), N,N'-dinaphthyl-N,N'-diphenylbenzidine (NPD) and 4,4',4"-tris(phenyl-3-tolylamino)triphenylamine (MTDATA); and porphyrins represented by octaethylporphyrin (OEP), platinum octaethylporphyrin (PtOEP) and zinc tetraphenylporphyrin (ZnTPP). As polymeric compounds, main chain-type conjugated polymers such as polyhexylthiophene (P3HT) and methoxyethylhexyloxyphenylenevinylene (MEHPPV), and side chain-type polymers represented by polyvinyl carbazole may be mentioned.
The i-layer can be formed by mixing the material for the p-layer and the material for the n-layer.

[Electrodes]

It is only necessary that one of the pair of electrodes (the upper electrode and the lower electrode) in the organic thin film solar cell of the invention is an electrode which transmits light. For instance, at least one of the pair of electrodes has a light transmittance of 10% or more for light having a wavelength of 300 to 800 nm. Here, the transmittance of an electrode can be measured using a transmittance measurement apparatus (for example, spectrometer UV-3100 manufactured by Shimadzu Corporation).

For the upper electrode and the lower electrode, electrodes made of known conductive materials can be used. As the electrode connecting with the p-layer, electrodes made of tin-doped indium oxide (ITO) or metals such as gold (Au), osmium (Os) or palladium (Pd) can be used.

As the electrode connecting with the n-layer, an electrode made of a metal such as silver (Ag), aluminum (Al), indium (In), calcium (Ca), platinum (Pt) or lithium (Li), an electrode made of a binary metal system such as Mg:Ag, Mg: In or Al: Li, and an electrode connecting the above-mentioned p-layer can be used.

To obtain the efficient photoelectric conversion property, at least one of the electrodes of the solar cell preferably has sufficient transparency to the solar spectrum. The transparent electrode can be formed of a known conductive material by deposition, sputtering or the like such that the predetermined light transmittance is secured.

Preferably, one of the pair of electrodes contains a metal having a large work function and another contains a metal having a small work function.

[Buffer layer]

In general, an organic thin film solar cell has a small film thickness, thus, the upper electrode and the lower electrode often short-circuit so that yield in fabrication of the cells may decrease. Such short-circuit can be avoided by stacking of a buffer layer.

As materials for formation of the buffer layer, preferred are compounds having a sufficiently high carrier mobility such that the short-circuit current does not decrease even when the film thickness of the buffer layer increases. Examples of the material for the buffer layer include aromatic cyclic acid anhydrides represented by NTCDA as shown below, as a low molecular compound, and known conductive polymers represented by poly(3,4-ethylenedioxy)thiophene:polystyrene sulfonate (PEDOT:PSS) and polyaniline:camphor sulfonic acid (PANI:CSA).

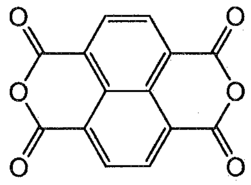

NTCDA

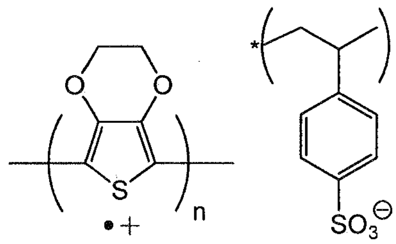

PEDOT:PSS

The buffer layer may have a role of preventing excitons from deactivation due to diffusion to the electrode. It is effective for enhancing the efficiency that the buffer layer is inserted as an exciton blocking layer. The exciton blocking layer may be inserted into each of the anode side and the cathode side, and may also be inserted into both the sides at the same time.

Preferred materials for the exciton blocking layer include known materials for the hole barrier layer and for the electron barrier layer in organic EL devices. Preferred materials for the hole barrier layer are compounds having a sufficiently large ionization potential. Preferred materials for the electron barrier layer are compounds having a sufficiently small electron affinity.

Specifically, bathocuproin (BCP), bathophenanthroline (BPhen) and the like, which are known as the materials for organic EL devices, may be mentioned as the material for the hole barrier layer on the cathode side.

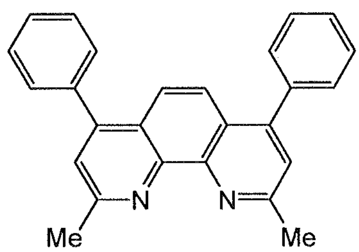

BCP

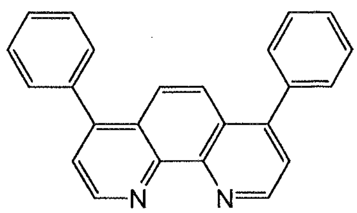

BPhen

In addition to the above-mentioned compounds, the inorganic semiconductor compounds exemplified as the above-mentioned materials for the n-layer may be used as materials for the buffer layer. Further, CdTe, p-Si, SiC, GaAs, $WO_3$ and the like which are p-type inorganic semiconductor compounds may be used.

[Substrate]

A substrate preferably has the mechanical strengths and heat resistance and transparency. Examples of the substrate include glass substrates and transparent resin films.
The transparent resin films include films made of polyethylene, ethylene-vinyl acetate copolymer, ethylene-vinylalcohol copolymer, polypropylene, polystyrene, poly(methyl methacrylate), polyvinylchloride, polyvinylalcohol, polyvinylbutyral, nylon, polyether ether ketone, polysulfone, polyether sulfone, tetrafluoroethylene-perfluoroalkylvinyl ether copolymer, polyvinylfluoride, tetrafluoroethylene-ethylene copolymer, tetrafluoroethylene-hexafluoropropylene copolymer, polychlorotrifluoroethylene, polyvinylidene fluoride, polyester, polycarbonate, polyurethane, polyimide, polyetherimide, polyimide and polypropylene.

[Film-forming method]

The method of forming each layer in the organic thin film solar cell of the invention is not particularly limited. Specifically, dry film-forming methods such as vacuum vapor deposition, sputtering plasma coating, and ion plating, and wet film-forming methods such as spin coating, dip coating, casting, roll coating, flow coating and inkjet can be applied. Preferred film-forming method is the vacuum vapor deposition method.

In the case of employing the dry film-forming method, known resistance heating methods are preferable. In the case of forming a mixture layer, the film-forming method in which co-deposition is conducted using plural evaporation sources is preferable, for example. Further preferred is to control the substrate temperature during film-formation.

In the case of employing the wet film-forming method, a material for forming each layer is dissolved or dispersed in an appropriate solvent to prepare a luminescent organic solution, and a thin film is formed from the solution. The solvent can be arbitrarily selected.
The solvent includes halogenated hydrocarbon solvents such as dichloromethane, dichloroethane, chloroform, carbon tetrachloride, tetrachloroethane, trichloroethane, chlorobenzene, dichlorobenzene and chlorotoluene; ether solvents such as dibutyl ether, tetrahydrofuran, dioxane and anisole; alcohol solvents such as methanol, ethanol, propanol, butanol, pentanol, hexanol, cyclohexanol, methyl cellosolve, ethyl cellosolve and ethylene glycol; hydrocarbon solvents such as benzene, toluene, xylene, ethylbenzene, hexane, octane, decane and tetralin; and ester solvents such as ethyl acetate, butyl acetate and amyl acetate. Of these, the hydrocarbon-type solvents and the ether solvents are preferable. These solvents may be used alone or in a mixture of plural kinds. However, usable solvents are not limited thereto.

The film thickness of each layer is not particularly limited, but the film can be made into an appropriate film thickness.
It is generally known that the exciton diffusion length of an organic thin film is short. If the film thickness is too thick, excitons may be deactivated before they reach the hetero interface, so that photoelectric conversion efficiency becomes low.
On the other hand, if the film thickness is too thin, pinholes or other defects may occur. As a result, the sufficient diode property cannot be obtained, so that the conversion efficiency may be lowered. The appropriate film thickness of each layer is usually in a range of 1 nm to 10 $\mu$m, and more preferably in a range of 5 nm to 0.2 $\mu$m.

In the invention, resins or additives suitable for the improvement of film-forming property or for the prevention of generating pinholes of the film, etc. may be used in the organic layers in the organic thin film solar cell.
Usable resins include insulating resins such as polystyrene, polycarbonate, polyarylate, polyester, polyamide, polyurethane, polysulfone, poly(methyl methacrylate), poly(methyl acrylate) and cellulose, and copolymers thereof; photoconductive resins such as poly-N-vinylcarbazole and polysilane; and conductive resins such as polythiophene and polypyrrole.
The additives include an antioxidant, an ultraviolet absorbent and a plasticizer.

EXAMPLES

The invention will be explained in detail with reference to examples, which should not be construed as limiting the scope of the invention.

Example 1

A glass substrate of 25 mm by 75 mm by 0.7 mm thick with an ITO transparent electrode (transmittance to light

having a wavelength of 300 to 800 nm: 60% or more) was subjected to ultrasonic cleaning with isopropyl alcohol for 5 minutes, and cleaned with ultraviolet rays and ozone for 30 minutes. The substrate with transparent electrode lines thus cleaned was mounted on a substrate holder in a vacuum deposition apparatus. A film of Compound 1 was formed by the resistance heating deposition at a deposition rate of 0.5 Å/s to form a p-layer having a thickness of 30 nm so as to cover the surface of the substrate on which the transparent electrode lines were formed as a lower electrode. Subsequently, a film of fullerene ($C_{60}$) was formed by the resistance heating deposition at a deposition rate of 0.5 Å/s to form on the p-layer an n-layer having a thickness of 60 nm. A film of BCP was formed by the resistance heating deposition to form on the n-layer a buffer layer having a thickness of 10 nm. Further, metal Al was deposited on the buffer layer as the upper electrode having a film thickness of 100 nm to obtain an organic thin film solar cell having an area of 0.05 $cm^2$. Table 1 indicates the composition ratios (molar ratios) of the organic compounds used for forming the organic layers (p-layer, n-layer and buffer layer).

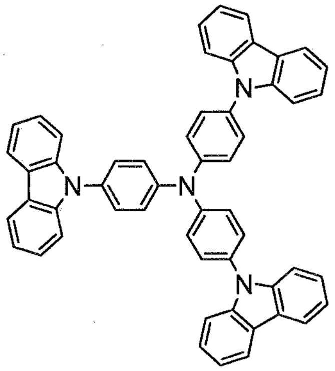

Compound 1

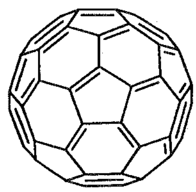

Fullerene

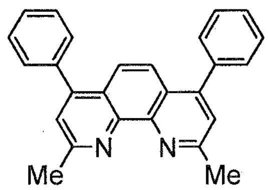

BCP

The I-V characteristic was determined for the organic thin film solar cell thus fabricated, under a condition of AM 1.5 (incident intensity (Pin): 100 $mW/cm^2$). Table 1 shows the resultant values of the open-circuit voltage (Voc), the short-circuit current density (Jsc), the fill factor (FF value) and the photoelectric conversion efficiency (η) of the organic thin film solar cell.
Here, the photoelectric conversion efficiency was derived by the following equation:

$$\eta\ (\%) = \frac{\mathrm{Voc} \times \mathrm{Jsc} \times \mathrm{FF}}{\mathrm{Pin}} \times 100$$

Compound 1 was formed into a thin film having a thickness of 50 nm. For the resultant film, the ionization potential (Ip) was measured in air using a photoelectron spectrometer (for example, AC-3 manufactured by Riken Keiki Co., Ltd.). For the thin film made of the above-mentioned Compound 1 which had a thickness of 50 nm, the energy gap (Eg) was also determined from the absorption edge wavelength of the absorption property using a spectrometer (UV-3100 manufactured by Shimadzu Corporation). The electron affinity Af (Af=Ip-Eg) of Compound 1 was computed from the Ip and Eg obtained.
The electron affinity Af of Compound B was also computed, and the difference in the affinity level, ΔAf, was computed. Table 1 shows the results.

Examples 2 to 7 and Comparative Examples 1 to 3

Each organic thin film solar cell was fabricated and evaluated in the same matter as in Example 1 except that the p-layer was formed of an organic compound shown in Table 1 in place of Compound 1, and that an organic layer was formed to have the composition ratio shown in Table 1.

Table 1 shows the results.

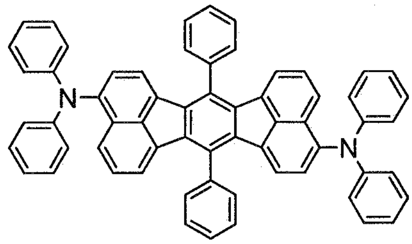

Compound 2

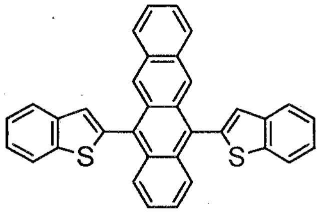

Compound 3

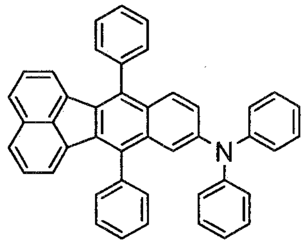

Compound 4

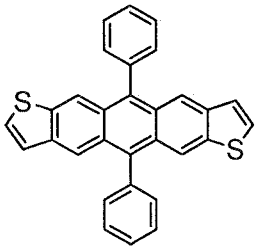

Compound 5

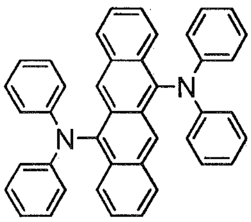

Compound 6

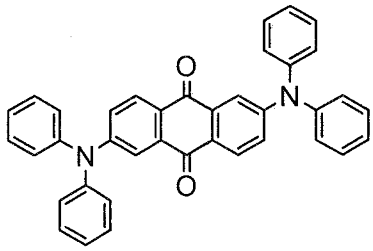

Compound 7

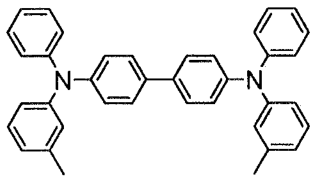

Compound 8

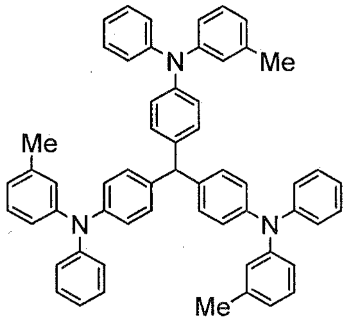

Compound 9

Lumogen F
(manufactured by BASF)

Compound 10

[Table 1]

| | P-layer | Composition ratio p-Layer compound: $C_{60}$:BCP [molar ratio] | Voc [V] | Jsc [mA/cm$^2$] | FF | η [%] | Eg [eV] | ΔAf [eV] |
|---|---|---|---|---|---|---|---|---|
| Example 1 | Compound 1 | 3:6:2 | 1.05 | 2.68 | 0.429 | 1.21 | 3.30 | 1.8 |
| Example 2 | Compound 2 | 13:30:10 | 0.98 | 4.37 | 0.453 | 1.93 | 2.10 | 0.8 |
| Example 3 | Compound 3 | 7:10:3 | 1.13 | 2.03 | 0.364 | 0.83 | 3.41 | 1.97 |
| Example 4 | Compound 4 | 2:3:1 | 0.99 | 3.66 | 0.443 | 1.60 | 2.67 | 1.5 |
| Example 5 | Compound 5 | 4:3:1 | 0.89 | 4.06 | 0.651 | 2.35 | 2.40 | 1.33 |
| Example 6 | Compound 6 | 18:30:10 | 0.92 | 3.96 | 0.449 | 1.63 | 2.05 | 0.7 |
| Example 7 | Compound 7 | 2:3:1 | 1.56 | 1.38 | 0.400 | 0.86 | 2.10 | 0.54 |

(continued)

| | P-layer | Composition ratio p-Layer compound: $C_{60}$:BCP [molar ratio] | Voc [V] | Jsc [mA/cm$^2$] | FF | η [%] | Eg [eV] | ΔAf [eV] |
|---|---|---|---|---|---|---|---|---|
| Comparative Example 1 | Compound 8 | 6:8:3 | 0.83 | 1.48 | 0.271 | 0.33 | - | 2.0 |
| Comparative Example 2 | Compound 9 | 4:8:3 | 0.85 | 0.85 | 0.303 | 0.22 | - | 2.21 |
| Comparative Example 3 | Compound 10 | 7:8:3 | 0.59 | 0.16 | 0.180 | 0.02 | - | 0.50 |

As is understood from Table 1, the conversion efficiency are significantly varied with the difference in the affinity level, ΔAf, of 0.5 eV and 2.0 eV being the boundary, and the organic thin film solar cells have a high conversion efficiency within a range of 0.5 eV<ΔAf<2.0 eV.

Examples 8 to 14 and Comparative Example 4

Ten organic thin film solar cells were fabricated in the same manner as in Example 1 except that a compound shown in Table 2 was used in place of Compound 1, that the p-layer was formed at a deposition temperature shown in Table 2, and that the area was changed to 0.5 cm$^2$.
The I-V characteristics was determined for the ten organic thin film solar cells thus fabricated under a condition of AM 1.5 (incident intensity (Pin): 100 mW/cm$^2$). As a result, when the curve of I-V characteristics of the organic thin film solar cell thus obtained has linear characteristics such that the curve passes through the origin as shown in Fig. 3, for example, it is defined that short-circuit of the organic thin film solar cell occurs. Table 2 shows the results.
[Table 2]

| | P-layer | Deposition temperature [°C] | Frequency of short-circuit |
|---|---|---|---|
| Example 8 | Compound 1 | 300 | 0 |
| Example 9 | Compound 2 | 380 | 0 |
| Example 10 | Compound 3 | 300 | 1 |
| Example 11 | Compound 4 | 270 | 0 |
| Example 12 | Compound 5 | 290 | 1 |
| Example 13 | Compound 6 | 350 | 0 |
| Example 14 | Compound 7 | 270 | 0 |
| Comparative Example 4 | Copper phthalocyanine | 500 | 3 |

As is understood from Table 2, less short-circuits occurs in the organic thin film solar cells in which the organic compound used for forming the p-layer is not a metal complex (Examples 8 to 14), in comparison with those in which the organic compound used for forming the p-layer is copper phthalocyanine, which is a metal complex (Comparative Example 4). Namely, by excluding metal complexes from the organic compounds used for forming the p-layer, organic solar cells can be produced with a high yield.

Example 15

An organic thin film solar cell was fabricated and evaluated in the same manner as in Example 1 except that the p-layer was formed of Compound 11 in place of Compound 1.
The composition ratio (in molar ratio) of Compound 11, fullerene and BCP was 6:8:3.
As a result, the following was found: Voc=0.33 V, Jsc=3.6 mA/cm$^2$, FF=0.44, η=0.52% and ΔAf=1.2 eV.

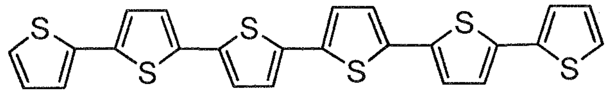

Compound 11

As is understood from the results above, when comparing the photoelectric conversion efficiency obtained in Example 15 with those obtained in Examples 1 to 7, preferred main organic compounds used for forming the p-layer are organic compounds having an amino group, a carbazolyl group or a fused aromatic polycyclic moiety.

Example 16

A glass substrate of 25 mm by 75 mm by 0.7 mm thick with an ITO transparent electrode was subjected to ultrasonic cleaning with isopropyl alcohol for 5 minutes, and cleaned with ultraviolet rays and ozone for 30 minutes. The substrate with transparent electrode lines thus cleaned was mounted on a substrate holder in a vacuum deposition apparatus. A film of Compound 4 was formed by the resistance heating deposition at a deposition rate of 1 Å/s to form a p-layer having a thickness of 5 nm so as to cover the surface of the substrate on which the transparent electrode lines were formed as a lower electrode. Subsequently, Compound 4 and fullerene were co-deposited each at a deposition rate of 0.2 Å/s to form on the p-layer an i-layer having a thickness of 15 nm (mixing ratio of Compound 4:fullerene= 2:3 (in molar ratio)). A film of fullerene was formed by the resistance heating deposition at a deposition rate of 1 Å/s to form on the i-layer an n-layer having a thickness of 45 nm. A film of BCP was formed by the resistance heating deposition to form on the n-layer a buffer layer having a thickness of 10 nm. Further, metal Al was deposited as the upper electrode on the buffer layer to a film thickness of 80 nm to obtain an organic thin film solar cell having an area of 0.5 $cm^2$.
The composition ratios (in molar ratio) of Compound 4, fullerene and BCP used for forming the organic layer was 2:3:1.
The organic thin film solar cell fabricated was evaluated in the same manner as in Example 1. As a result, the following was found: Voc=0.91 V, Jsc=4.2 mA/$cm^2$, FF=0.451, $\eta$=1.72% and $\Delta$Af=1.5 eV.
As is understood from the results above, when comparing the photoelectric conversion efficiency of Example 16 with that of Example 4, at least one organic layer is preferably a mixture layer of two or more organic compounds.

INDUSTRIAL APPLICABILITY

The organic thin film solar cell of the invention can be used as a power source for a clock, a mobile cell, a mobile personal computer, or the like.
Several embodiments and/or examples of the invention were explained above in detail. A person skilled in the art can easily add many modifications to these embodiments and/examples, without essentially deviating from the novel teachings and advantageous effects of the invention. Accordingly, these many modifications are included in the scope of the invention.
The documents described in the specification are incorporated herein by reference in its entirety.

**Claims**

1. An organic thin film solar cell comprising a pair of electrodes and one or more organic layers formed of two or more organic compounds, which are between the pair of electrodes,
wherein a difference ($\Delta$Af) in affinity level between two main organic compounds of the two or more organic compounds satisfies the following equation (a):

$$0.5\ eV<\Delta Af<2.0\ eV \quad \cdots (a).$$

2. The organic thin film solar cell according to claim 1, wherein at least one organic layer of the one or more organic layers is a mixture layer in which two or more organic compounds are mixed.

3. The organic thin film solar cell according to claim 1, wherein the one or more organic layers are two or more organic

layers, and each of the two or more organic layers is formed of any one of the two or more organic compounds.

**4.** The organic thin film solar cell according to any one of claims 1 to 3, wherein the one or more organic layers comprise a p-layer, and at least one of the two main organic compounds is a main organic compound forming the p-layer.

**5.** The organic thin film solar cell according to claim 4, wherein the main organic compound forming the p-layer has an energy gap Eg of 3 eV or more.

**6.** The organic thin film solar cell according to claim 4 or 5, wherein the main organic compound forming the p-layer has an amino group, a carbazolyl group or a fused aromatic polycyclic moiety.

**7.** The organic thin film solar cell according to any one of claims 1 to 6, wherein the two or more organic compounds are not metal complexes.

FIG.1

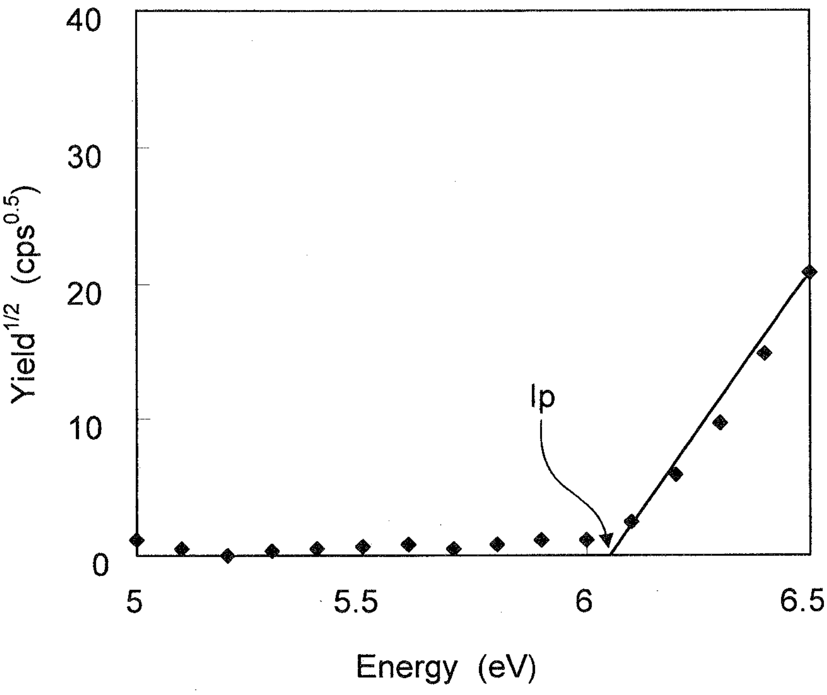
40
30
20
10
0
Yield$^{1/2}$ (cps$^{0.5}$)
Ip
5
5.5
6
6.5
Energy (eV)

FIG.2

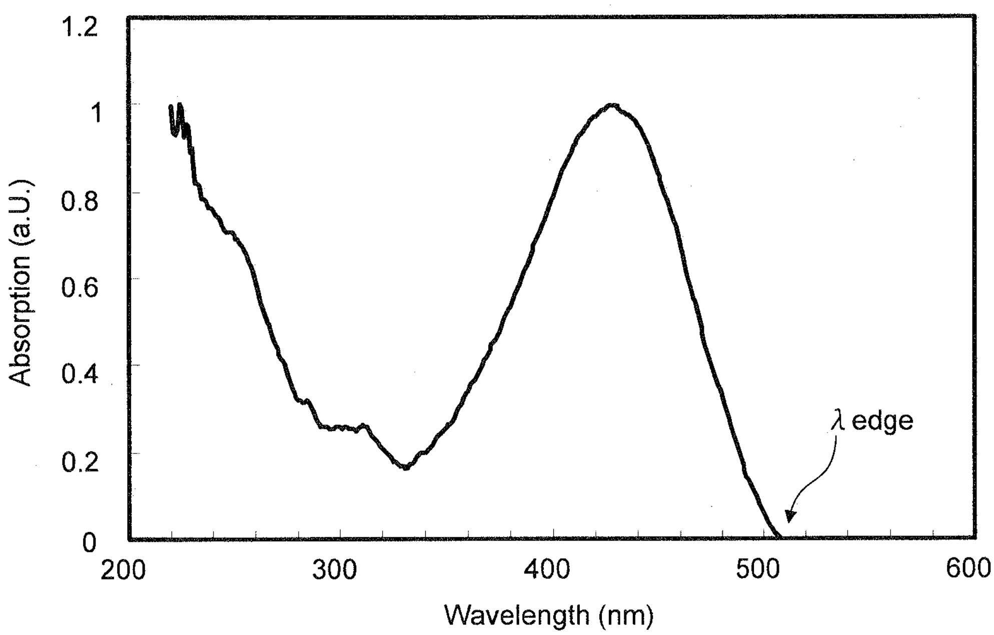
1.2
1
0.8
0.6
0.4
0.2
0
Absorption (a.U.)
λ edge
200
300
400
500
600
Wavelength (nm)

FIG.3

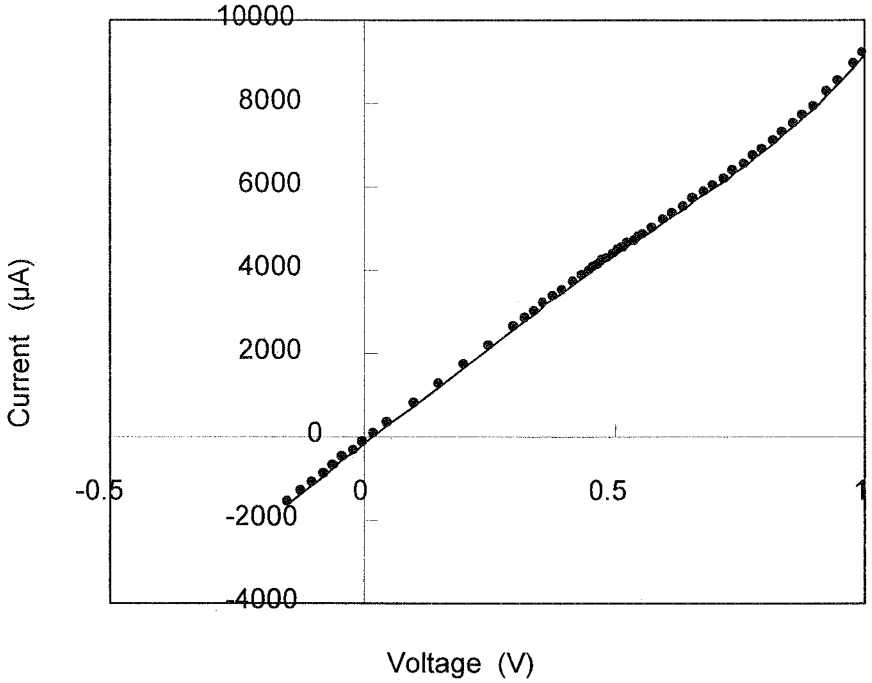
10000
8000
6000
4000
2000
0
-2000
-4000
Current (μA)
-0.5
0
0.5
1
Voltage (V)

## INTERNATIONAL SEARCH REPORT

International application No.
PCT/JP2009/005693

**A. CLASSIFICATION OF SUBJECT MATTER**
*H01L51/42*(2006.01)i

According to International Patent Classification (IPC) or to both national classification and IPC

**B. FIELDS SEARCHED**

Minimum documentation searched (classification system followed by classification symbols)
H01L51/42-51/48

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)
JSTPlus(JDreamII), JST7580(JDreamII)

**C. DOCUMENTS CONSIDERED TO BE RELEVANT**

| Category* | Citation of document, with indication, where appropriate, of the relevant passages | Relevant to claim No. |
|---|---|---|
| X | JP 2008-34764 A (National Institute of Advanced Industrial Science and Technology), 14 February 2008 (14.02.2008), paragraphs [0009] to [0015]; fig. 1 to 2 (Family: none) | 1-5,7 |
| A | JP 2008-166561 A (Idemitsu Kosan Co., Ltd.), 17 July 2008 (17.07.2008), paragraphs [0067] to [0073] (Family: none) | 6 |
| A | WO 01/23497 A1 (Idemitsu Kosan Co., Ltd.), 05 April 2001 (05.04.2001), column 53, line 10 to column 54, line 6 & US 2006/0024523 A1 & EP 1138745 A1 & DE 60034105 T & TW 490990 B & AT 358169 T & CN 1327468 A | 6 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 21 January, 2010 (21.01.10) | 02 February, 2010 (02.02.10) |
| Name and mailing address of the ISA/ Japanese Patent Office | Authorized officer |
| Facsimile No. | Telephone No. |

Form PCT/ISA/210 (second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2002076027 A
- JP 2004165516 A
- JP 2006355358 A
- JP 2007283102 A
- JP 2008112795 A
- JP 2008034764 A